Europäisches Patentamt

European Patent Office

Office européen des brevets

(19)

(11) Numéro de publication: **0 003 273**
**B1**

(12) **FASCICULE DE BREVET EUROPEEN**

(21) Numéro de dépôt: **78400266.9**

(22) Date de dépôt: **27.12.78**

(51) Int. Cl.³: **H 01 S 3/13, H 01 L 33/00**

(54) Dispositif d'alimentation de source lumineuse à semiconducteur

(30) Priorité: **20.01.78 FR 7801637**

(43) Date de publication de la demande:
**08.08.79 Bulletin 79/16**

(45) Mention de la délivrance du brevet:
**17.09.80 Bulletin 80/19**

(84) Etats contractants désignés:
**DE GB IT NL**

(56) Documents cités:
**FR - A - 2 353 198**
**FR - A - 2 386 165**

**INSTRUMENTS AND EXPERIMENTAL TECHNIQUES**
**vol. 19, n° 2, part 2,**
**mars-avril 1976, pages 519—522**
**New York US**
**P. V. DERNOVSKII et al.: "Compact 1.06μ Laser-**
**Radiation Simulator"**

**RCA TECHNICAL NOTES, no 1005, 9**
**avril 1975, pages 1—3,**
**Princeton, New York US**
**J. P. WITTKE et al.: "Stabilization of CW Injection**
**Lasers".**

(73) Titulaire: **"THOMSON-CSF" - SCPI**
**173, Boulevard Haussmann**
**F - 75360 Paris, Cedex 08 (FR)**

(72) Inventeur: **Malissin, Roland**
**"THOMSON-CSF" - SCPI 173, bld Haussmann**
**F - 75360 Paris Cedex 08 (FR)**
**Lecomte, Daniel**
**"THOMSON-CSF" - SCPI 173, bld Haussmann**
**F - 75360 Paris Cedex 08 (FR)**

(74) Mandataire: **Desperrier, Jean-Louis**
**"THOMSON-CSF" - SCPI 173, Bld Haussmann**
**F - 75360 Paris Cedex 08 (FR)**

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition. (Art. 99(1) Convention sur le brevet européen).

Courier Press, Leamington Spa, England.

Dispositif d'alimentation de source lumineuse à semiconducteur.

L'invention se rapporte aux sources lumineuses à semiconducteurs, lasers à semiconducteur ou diodes émettrices de lumière LED, et plus particulièrement à un dispositif d'alimentation perfectionné tant lors de la mise en marche de la source ou de son interruption qu'en régime établi.

En effet, plusieurs problèmes se posent pour l'alimentation des sources à semiconducteurs: en régime établi, il est nécessaire de prévoir un dispositif d'alimentation de la source comportant un dispositif de régulation afin de maintenir sensiblement constante le puissance de sortie de cette source. De plus lors de la mise en route du dispositif d'alimentation il est nécessaire de prévoir un dispositif permettant d'arriver progressivement au régime de fonctionnement. Enfin, lors de la mise en marche ou de l'interruption, les impulsions parasites prenant naissance dans les circuits électroniques ne doivent pas atteindre la source qui risque d'être détérioré par l'effet de ces impulsions parasites.

D'autres précautions doivent être prises pour l'alimentation de lasers semiconducteurs de puissance lorsque ces lasers sont destinés à fonctionner dans des gammes de température larges. Il est connu d'utiliser dans de tels dispositifs un dispositif de régulation thermique du laser en agissant sur sa température au moyen d'un frigatron. Mais un tel dispositif ne permet qu'une régulation lente.

Les lasers de faible puissance (inférieure à 5 mW) fonctionnant dans la gamme de température ambiante (température inférieure à 60°C) ne nécessitent pas de dispositifs de régulation thermique car dans cette gamme de température, le laser ne risque pas d'être détérioré. Par conséquent, il est possible de réguler la puissance de sortie du laser en faisant seulement varier le courant d'alimentation.

Les dispositifs de régulation (thermique ou électronique) connus comportent une cellule photoélectrique fournissant un signal caractéristique des variations de la puissance de sortie du laser par prélèvement d'une partie du rayonnement émis par le laser, qui est soit une partie du rayonnement avant dans la direction de propagation, soit la rayonnement émis vers l'arrière du semiconducteur.

L'invention a pour but de fournir un dispositif d'alimentation d'une source lumineuse à semiconducteur comportant un dispositif de régulation électrique pour maintenir constante la puissance de sortie de cette source en agissant sur son courant d'alimentation en régime de fonctionnement et pour établir ce régime en évitant les inconvénients sus-mentionnés, en particulier les impulsions parasites et les phénomènes transitoires. Un dispositif de régulation thermique peut être également prévu lorsqu'il est souhaitable d'étendre la gamme de température de fonctionnement, le dispositif de régulation électrique permettant d'augmenter la vitesse de réponse de la boucle de régulation thermique.

L'invention sera mieux comprise et d'autres caractéristiques apparaîtront à l'aide de la description qui suit en référence aux figures annexées.

La figure 1 représente une réseau de courbes représentant à température constante les variations de puissance de sortie d'un laser semiconducteur en fonction du courant d'alimentation.

La figure 2 représente un schéma du dispositif d'alimentation de laser semiconducteur selon l'invention.

La figure 3 représente schématiquement, en fonction du temps, les signaux présents en différents points du dispositif d'alimentation.

Dans la suite, il est fait référence au laser à semiconducteur mais la description n'est pas limitée à ce type de source et est également valable pour les diodes émettrices de lumière LED.

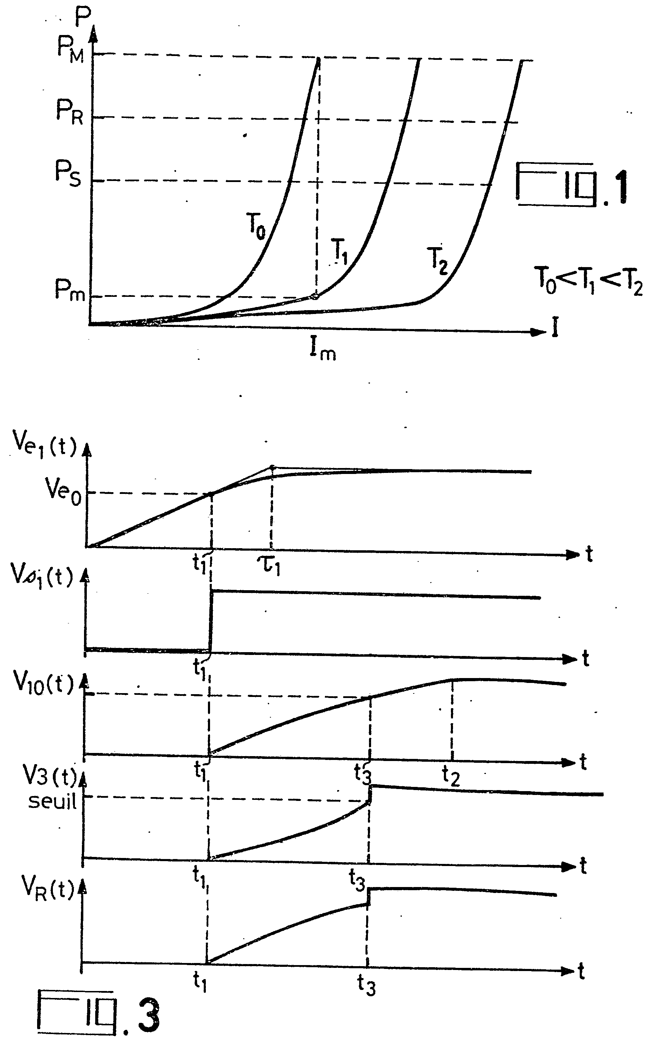

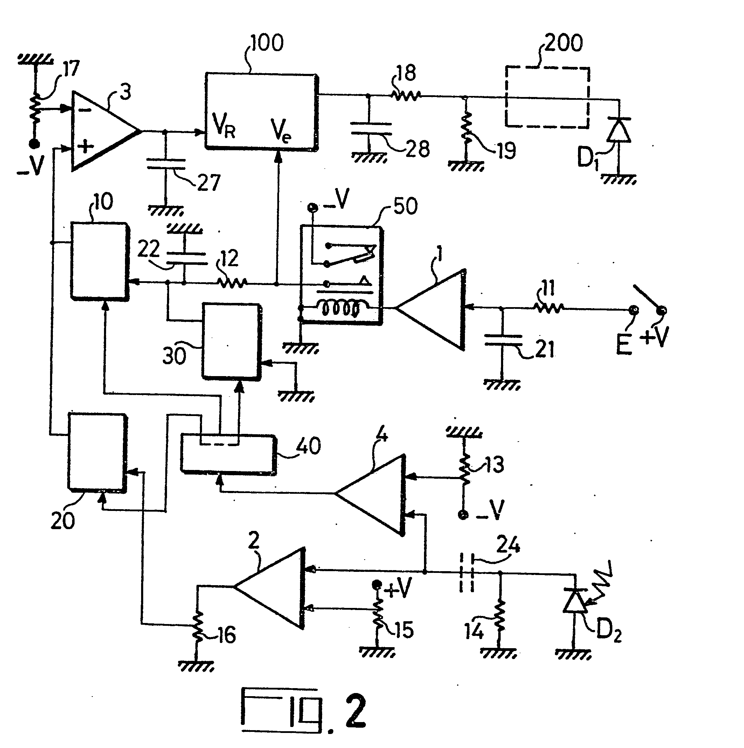

La figure 1 représente la variation de puissance de sortie P du laser en fonction du courant d'alimentation I à température constante pour trois températures différentes $T_0$, $T_1$ et $T_2$ telles que $T_0 < T_1 < T_2$.

Pour éviter les défauts de fonctionnement du laser lors de la mise sous tension, les circuits d'alimentation délivrent au laser une rampe de tension de commande. Cette rampe par d'une valeur minimum de tension $V_m$ telle que, à la température la plus basse de fonctionnement du laser, le courant ne dépasse pas le seuil $I_m$ correspondant à la puissance maximale $P_M$ tolérable pour le laser. Les courbes montrent en effet que si le courant $I_m$ est fixé, la puissance de sortie maximale $P_M$ sera atteinte à la température $T_0$. De plus sur cette figure la puissance $P_s$ est la puissance de seuil du laser à partir de laquelle le régime transitoire est considéré comme terminé et $P_r$ est la puissance à laquelle le laser semiconducteur est régulé.

La figure 2 représente le schéma du dispositif d'alimentation du laser comportant un dispositif de commutation électronique automatique fermant une boucle de régulation de puissance après le régime transitoire, le laser étant alimenté pendant le régime transitoire par une rampe de tension.

Le laser semiconducteur est schématisé sur la figure 2 par une diode émissive $D_1$. Ce laser semiconducteur est alimenté par un régulateur de tension 100 dont la sortie est reliée à la diode $D_1$ par l'intermédiaire d'un circuit de filtrage formé de la capacité 28 et de la résistance 18, et d'une résistance 19 en parallèle sur la diode $D_1$. Le circuit de filtrage permet de diminuer l'effet d'impulsions parasites qui pourraient arriver en ce point de l'alimentation et la résistance 19 est une charge qui évite la formation d'impulsions lorsque le dispositif d'alimentation du laser est débranché.

Le régulateur 100 est tel qu'il transmet à la sortie un signal $V_s$ qui est le signal d'entrée $V_e$ régulé au moyen d'un signal de référence $V_R$. Le dispositif d'alimentation est conçu pour qu'un signal d'entrée $V_e$ ne soit appliqué au régulateur qu'après une durée suffisante après la mise sous tension des circuits afin que le signal ait un niveau déjà stabilisé. Un système temporisateur permet de n'appliquer $V_e$ qu'après un temps $t_1$. Pour cela le signal d'entrée, qui est la tension d'alimentation +V appliquée à la borne E, est transmis à un amplificateur 1 par l'intermédiaire d'un circuit formé d'une résistance 11 et d'une capacité 21 de constante de temps $\tau_1$. La sortie de l'amplificateur fonctionnant en tout ou rien est reliée à l'entrée de l'enroulement d'un relais 50 dont l'autre extrémité est connectée à la masse. Le relais est alimenté par le circuit amplificateur 1; quand la tension de seuil $V_{eo}$ est établie à l'entrée de ce circuit, après $t_1 < \tau_1$, la tension — V est appliquée à la borne d'entrée du régulateur.

Le signal de référence $V_R$ appliqué à l'entrée de référence du régulateur 100 est le signal de sortie d'un amplificateur 3 dont le niveau est réglable par un potentiomètre 17 branché entre la masse et la potentiel —V et relié à l'entrée "—" de l'amplificateur 3; la borne "+" de cet amplificateur reçoit le signal utile destiné à la régulation soit par une première voie qui se termine par une porte 10, soit par une seconde voie qui se termine par une porte 20. Ces deux portes sont commandées par un basculeur 40 et sont l'une ouverte, l'autre fermée pendant la phase correspondant au régime transitoire et inversement pendant la phase correspondant au régime établi.

Pendant la phase transitoire, le signal utile pour la régulation est fourni par la première voie, la porte 10 étant alors ouverte. Cette voie utilise le signal de sortie du relais 50 appliqué à l'entrée de signal du régulateur 100, c'est-à-dire un signal constant, de niveau —V, présent à partir de l'instant $t_1$. Ce signal est appliqué à un circuit à résistance et capacité 12 et 22, de constante de temps $\tau_2$. La sortie de ce circuit délivre à l'entrée de la porte 10 une rampe de tension qui part de zéro à l'instant $t = t_1$ et qui est voisine de son maximum à l'instant $t_2 = t_1 + \tau_2$. La porte 10 transmet ce signal à l'entrée de l'amplificateur 3 et donc à l'entrée de référence du régulateur tant que cette porte est ouverte. Un condensateur 27 est connecté entre la sortie de l'amplificateur 3 et la masse et forme avec l'impédance de sortie de l'amplificateur un circuit de filtrage qui élimine les impulsions parasites susceptibles de prendre naissance dans le circuit en particulier lors de l'ouverture et de la fermeture des portes.

Cette première voie fournit le signal de référence au régulateur tant que le régime de fonctionnement n'est pas établi. Lorsque le régime est établi, le régulateur est commandé par un signal provenant de la seconde voie; cette voie est la boucle de contre réaction pour la régulation en puissance du laser. Elle est commandée par un signal issu d'une cellule photoélectrique, fonctionnant soit suivant le mode photovoltaïque soit suivant le mode photoconducteur, placée par exemple pour capter le rayonnement émis par la face arrière du semiconducteur. Cette cellule a été représentée sur le schéma sous la forme d'une diode réceptrice $D_2$ qui délivre un courant électrique. Une résistance 14 branchée aux bornes de la photocellule fournit une tension $V_4$ appliquée à l'entrée d'un amplificateur 2, dont l'autre entrée est reliée à un potentiomètre 15 branché entre la masse et le potentiel +V et dont la sortie est reliée à une borne d'un potentiomètre 16 de réglage du gain de boucle, l'autre borne du potentiomètre est reliée à la masse. La borne mobile est reliée à l'entrée de signal de la porte 20 dont la commande est effectuée comme indiqué ci-dessus par un basculeur 40. Le circuit de commande du basculeur 40 utilise également la tension $V_4$ qui se développe aux bornes de la résistance 14. Cette tension est appliquée à l'entrée de l'amplificateur à seuil 4 dont le seuil est fixé par un potentiomètre 13 branché entre la masse et —V et dont la borne mobile est reliée à l'entrée de référence de l'amplificateur à seuil. Le potentiomètre 13 permet de régler le seuil à partir duquel la boucle de réaction du laser est fermée, c'est-à-dire la puissance de seuil $P_s$ suffisante pour que le dispositif ait atteint la fin de la phase transitoire à partir de laquelle peut s'établir un régime de fonctionnement avec régulation de la puissance de sortie.

La figure 3 représente le diagramme des temps des signaux présents en différents points du dispositif.

Le premier signal représenté $V_{e1}$ (t) est le signal à l'entrée de l'amplificateur 1. A l'instant $t_1$, le signal de sortie de l'amplificateur 1, $V_{s1}$, change de niveau, le relais bascule et le signal correspondant —V est appliqué à l'entrée de signal du régulateur 100. Simultanément la porte 10 est ouverte. Le signal présent à l'entrée de cette porte $V_{10}$(t) est représenté sur la figure 3. C'est une rampe de tension qui part de zéro à l'instant $t_1$ et atteint une valeur voisine du maximum à $t_2 = t_1 + \tau_2$ et qui est également le signal $V_R$(t) appliqué à l'entrée de référence du régulateur (au niveau près) jusqu'à l'instant $t = t_3$. Cet instant $t_3$ est déterminé par l'amplificateur à seuil qui commande le basculement des portes 10 et 20, ouvrant la porte 20 et fermant la porte 10. Le signal $V_3$(t) à l'entrée de l'amplificateur à seuil est également représenté sur la figure 3. Ce signal part de zéro à l'instant $t_1$ (à partir de l'instant ou le laser commence à émettre) et augmente. Le signal de régulation à la sortie de l'amplificateur 2 est proportionnel à ce signal $V_3$(t). Le signal $V_R$(t) appliqué à l'entrée de référence du régulateur est à partir de $t = t_3$ un signal proportionnel à $V_3$(t).

Sur la figure 2, une porte 30 ouverte en même temps que la porte 20 a été représentée. Cette porte reliée à la masse permet de décharger le condensateur 22 à la fin de la période transitoire comme représenté sur la figure 3, $V_{10}(t)$ diminuant à partir de $t = t_3$. En effet, si par suite d'un mauvais fonctionnement la boucle de régulation était ouverte, simultanément la première voie serait validée et la tension maximale de la rampe (−V) serait appliquée au laser et pourait l'endommager. Au contraire, le circuit prévu permet de décharger rapidement la capacité avant que la tension maximale s'établisse.

Un certain nombre de perfectionnements peuvent être prévus à partir du dispositif représenté sur la figure 2, en particulier pour diminuer l'effet des variations de température. En effet, la sensibilité de la cellule photoélectrique, représentée par la diode $D_2$, augmente en fonction de la température et si la cellule est chargée par une résistance 14 ordinaire, le signal de commande augmentant, la régulateur a tendance à faire baisser la puissance de sortie du laser.

Pour s'affranchir des variations de sensibilité de la cellule photoélectrique, la résistance 14 est remplacée par un montage à résistances ordinaires et résistances à coefficient de température négatif dont la résistance totale varie en fonction de la température suivant une loi voisine de l'inverse de celle des variations de sensibilité. Ainsi, la puissance de sortie du laser est indépendante de l'effet de ces variations de température sur la cellule. De la même façon, la résistance 17 est ajustée dans le dispositif de la figure 2, pour que la valeur initiale de la tension de la rampe de commande du laser, et donc le courant correspondant, ne dépasse pas un seuil $I_m$ fixé par la puissance maximale tolérable par le laser à la température la plus basse de la gamme de fonctionnement comme le montre le réseau de courbes de la figure 1. Pour s'affranchir de cette contrainte, il est possible de remplacer le potentiomètre 17 par un montage à résistances ordinaires et résistances à coefficient de température négatif tel que, à la température du laser (ou à la température ambiante pour un laser de faible puissance), le courant $I_m$ décroisse quand la température décroit et inversement.

De plus le dispositif décrit est un dispositif d'alimentation d'un laser semiconducteur non modulé. Pour un laser à semiconducteur destiné à fonctionner en impulsions le circuit représenté sur la figure 2 doit être modifié en ajoutant entre la sortie du régulateur et le laser un modulateur 200 délivrant les impulsions de commande au laser ces impulsions ayant un niveau régulé. Pour cela, la photocellule $D_2$ est suivie d'un circuit à résistance et capacité 14 et 24 qui délivre le signal crête du laser. Ces éléments (modulateur 200 et capacité 24) ont été représentés en pointillés sur la figure 2.

L'invention n'est pas limitée au mode de réalisation décrit et représenté. En particulier le rôle du circuit à résistance et capacité 11 et 21 de constante de temps $\tau_1$ peut être obtenu par l'alimentation elle-même dans la mesure où il y a un temps de montée en régime. De plus le circuit à résistance et capacité 12 et 22 peut être remplacé par un générateur de rampe qui revient à zéro et y reste après que le maximum de la rampe ait été atteint. Dans ce cas la porte 30 destinée à la décharge du condensateur 22 est inutile.

Enfin le relais 50 est placé entre l'entrée du dispositif d'alimentation et l'entrée du régulateur 100 pour interrompre la liaison d'entrée tant qu'une certaine tension de seuil n'est pas atteinte de façon à ce que le laser ne soit pas alimenté. Il est également possible, sans sortir du cadre de l'invention, d'interrompre la liaison entre la sortie du régulateur 100 et le laser en plaçant le relais dans cette liaison.

Le depositif d'alimentation représenté sur la figure 2 dans lequel la résistance 14, $D_1$ et $D_2$ sont en fait logés au même endroit, permet d'obtenir une régulation meilleure que 1% sans précaution particulière lors de la mise en marche ou de l'interruption du laser ni pendant le fonctionnement en régime établi de ce même laser dans une gamme de température ambiante 20°C à 60°C.

Pour élargir la gamme de température de fonctionnement, en particulier pour les lasers semiconducteur de puissance, le dispositif d'alimentation du laser comportera, en plus de la boucle de régulation électrique commandée par un signal caractéristique de la puissance émise par le laser, une boucle de régulation thermique utilisant un senseur thermique, cette boucle étant donc indépendente de la puissance de sortie du laser. Un tel dispositif permet alors d'une part de maintenir le laser à une température suffisamment basse pour une bonne durée de vie et d'autre part de réguler sa puissance de sortie.

L'invention est applicable, par example, à l'alimentation de lasers semiconducteurs pour l'inscription ou la lecture de vidéodisques inscriptibles ou lisibles optiquement ou à l'alimentation de systèmes de télécommunications optiques.

**Revendications**

1. Dispositif d'alimentation de source lumineuse à semiconducteur comportant une boucle de régulation de puissance commandée par un signal caractéristique de la puissance émise par la source et un circuit de commande de la source, caractérisé en ce qu'il comporte en outre un générateur de rampe relié à une première entrée d'un circuit de commutation, la sortie de la boucle de régulation étant reliée à une seconde entrée du circuit de commutation dont la sortie est reliée à l'entrée du circuit de commande, le circuit de commutation comportant une entrée de commande destinée à recevoir le signal caractéristique de la puissance émise pour relier la sortie du circuit de commutation à sa première entrée pendant le phase transitoire et à sa seconde entrée pendant la phase établie, la fin de la phase transitoire étant déterminé lorsqu'un seuil prédeterminé de puissance est atteint.

2. Dispositif selon la revendication 1, caractérisé en ce qu'une cellule photosensible destinée à capter une fraction du rayonnement émis par le laser délivre le signal caractéristique de la puissance émise, la boucle de régulation comportant une impédance de charge aux bornes de la cellule comportant une résistance à coefficient de température négatif pour compenser les variations de sensibilité de la cellule en fonction de la température.

3. Dispositif selon la revendication 2, caractérisé en ce que le générateur de rample est destiné à fournir un signal dont le niveau de départ est fixé par un circuit résistif dont la résistance varie en fonction de la température pour augmenter le courant de commande lorsque la température augmente et inversement.

4. Dispositif selon une quelconque des revendications précédentes, caractérisé en ce qu'il comporte en outre un dispositif de déclenchement du générateur de rampe commandé par la mise sous tension du dispositif d'alimentation avec un temps de retard correspondant au temps de montée de la tension d'alimentation.

5. Dispositif selon l'une quelconque des revendications précédentes, caractérisé en ce qu'il comporte de plus une voie de régulation thermique, pour maintenir le laser dans une gamme de température déterminée pour lui assurer une bonne durée de vie, le dispositif comportant en outre un senseur thermique et un dispositif de refroidissement.

6. Dispositif selon l'une quelconque des revendications précédentes, caractérisé en ce que la source lumineuse à semiconducteur est une source laser.

7. Dispositif selon l'une quelconque des revendications 1 à 5, caractèrisè en ce que la source lumineuse à semiconducteur est une diode émettrice de lumière.

## Claims

1. Power supply apparatus for a semiconductor light source comprising a power control loop which is controlled by a signal which is characteristic of the power emitted by the source, and a control circuit for the source, characterized in that it also comprises a ramp generator which is connected to a first input of a switch-over circuit, that the output of the control loop is connected to a second input of the switch-over circuit whose output is connected to the input of the control circuit, that the switch-over circuit comprises a control input which is intended to receive the signal characteristic of the emitted power so that the output of the switch-over circuit is connected in the transient phase to the first input thereof and in the steady phase to the second input thereof, the end of the transient phase being determined when a predetermined power threshold value is reached.

2. Apparatus according to claim 1, characterized in that a photosensitive cell which is intended to capture a fraction of the radiation emitted by the laser delivers the signal characteristic of the emitted power, and that the control loop comprises at the terminals of the cell a load impedance which for compensation of temperature-dependent sensitivity variations of the cell has a resistance with negative temperature coefficient.

3. Apparatus according to claim 2, characterized in that the ramp generator is intended to supply a signal whose initial value is defined by a resistance circuit whose resistance changes as a function of the temperature so that the control current is increased when the temperature increases and vice-versa.

4. Apparatus according to any one of the preceding claims, characterized in that it also includes a trigger device for the ramp generator which is actuated by applying the supply voltage to the power supply means with a time delay corresponding to the rise time of the supply voltage.

5. Apparatus according to any one of the preceding claims, characterized in that it also includes a thermal control channel which holds the laser in a determined temperature range so that a good life is imparted thereto, and that the apparatus also includes a heat sensor and a cooling means.

6. Apparatus according to any one of the preceding claims, characterized in that the semiconductor light source is a laser source.

7. Apparatus according to any one of claims 1 to 5, characterized in that the semiconductor light source is a light-emitting diode.

## Patentsprüche

1. Stromversorgungsgerät für eine Halbleiterlichtquelle mit einer Leistungsregelschleife, die von einem Signal gesteuert wird, das charakteristisch für die von der Quelle abgestrahlte Leistung ist, und mit einer Steuerschaltung für die Quelle, dadurch gekennzeichnet, daß sie außerdem einen Rampengenerator enthält, der mit einem ersten Eingang einer Umschalt-Schaltung verbunden ist, daß der Ausgang der Regelschleife mit einem zweiten Eingang der Umschalt-Schaltung verbunden ist, deren Ausgang mit dem Eingang der Steuerschaltung verbunden ist, daß die Umschalt-Schaltung einen Steuereingang aufweist, der dazu bestimmt ist, das für die abgestrahlte Leistung charakteristische Signal zu empfangen, damit der Ausgang der Umschalt-Schaltung in der Einschwingphase mit ihrem ersten Eingang und in der eingeschwungenen Phase mit ihrem zweiten Eingang verbunden wird, wobei das Ende der Einschwingphase dann vorliegt, wenn ein vorbestimmter Leistungsschwellenwert erreicht wird.

2. Gerät nach Anspruch 1, dadurch gekennzeichnet, daß eine lichtempfindliche Zelle, die dazu bestimmt ist, einen Bruchteil der von dem Laser abgestrahlten Strahlung aufzufangen, das für die abgestrahlte Leistung charakteristische Signal liefert, und daß die Regelschleife an den Klemmen der Zelle eine Lastimpedanz aufweist, die zur Kompensation der temperaturabhängigen Empfindlichkeitsschwankungen der Zelle einen Widerstand mit negativem Temperaturkoeffizienten hat.

3. Gerät nach Anspruch 2, dadurch gekennzeichnet, daß der Rampengenerator dazu bestimmt ist, ein Signal zu liefern, dessen Anfangswert von einer Widerstandsschaltung festgelegt ist, deren Widerstand sich temperatureabhängig ändert, damit der Steuerstrom vergrößert wird, wenn die Temperatur steigt, und umgekehrt.

4. Gerät nach einem der vorhergehenden Ansprüche, dadurch gekennzeichnet, daß es außerdem eine Auslösevorrichtung für den Rampengenerator enthält, die durch das Anlegen der Versorgungsspannung an das Gerät mit einer der Anstiegszeit der Ver-sorgungsspannung entsprechenden Zeit-verzögerung betätigt wird.

5. Gerät nach einem der vorhergehenden Ansprüche, dadurch gekennzeichnet, daß es außerdem einen thermischen Regelkanal enthält, der den Laser in einem bestimmten Temperaturbereich hält, damit ihm eine gute Lebensdauer verliehen wird, und daß das Gerät außerdem einen Wärmefühler und eine Kühlvorrichtung enthält.

6. Gerät nach einem der vorhergehenden Ansprüche, dadurch gekennzeichnet, daß die Halbleiterlichtquelle eine Laserquelle ist.

7. Gerät nach einem der Ansprüche 1 bis 5, dadurch gekennzeichnet, daß die Halbleiter-lichtquelle eine Leuchtdiode ist.

$P$

$P_M$

$P_R$

$P_S$

$P_m$

$T_0$

$T_1$

$T_2$

$\text{Fig}.1$

$T_0 < T_1 < T_2$

$I$

$I_m$

$V_{e_1}(t)$

$Ve_0$

$t_1$

$\tau_1$

$t$

$V_{s_1}(t)$

$t_1$

$t$

$V_{10}(t)$

$t_1$

$t_3$

$t_2$

$t$

$V_3(t)$

seuil

$t_1$

$t_3$

$t$

$V_R(t)$

$t_1$

$t_3$

$t$

$\text{Fig}.3$

Fig. 2